# EUROPEAN PATENT APPLICATION

(11) **EP 1 796 024 A1**
(43) Date of publication of application: **13.06.2007**
(21) Application number: 05111835.4
(22) Date of filing: 08.12.2005
(51) Int. Cl.: G06K 19/077

(54) **Method for the connection of a printed antenna with a RFID module and unit produced by said method**

(71) Applicant: Assa Abloy Identification Technology Group AB, 10723 Stockholm (SE)
(72) Inventor: Ayala, Stéphane, 1607 Palézieux Gare (CH)
(74) Representative: Grosfillier, Philippe

(57) **Abstract**

The method comprises the successive following steps:
• creating a recess at least in a surface of a basic substrate of the unit
• placing the transponder chip module face down in the recess, the transponder module having two lateral parts comprising each on their rear face an electrical contact surface such that the two lateral parts being are supported by the surface of the basic substrate
• printing a conductive antenna structure over the surface of the basic substrate, whereby two extremities of the antenna structure are printed each directly on one of said electrical contact surfaces, in order to achieve the electrical connection between the antenna and the chip module.

## Description

### Field of the Invention

The invention relates to a method of manufacture of a contactless unit in which the antenna is formed by printing (screen printing or ink jet technique for example).

The present invention also relates to a contactless RFID transponder unit, for example in the shape of a card.

### State of the art

As such, the production of antennas with printing technique is known in the art, for example from documents FR 2 753 305 and FR 2 853 115. To connect the chip to the antenna, contact zones are printed at the end of the printed conductive pads forming the antenna, and the chip/module is then placed over these zones in order that its bumps are electrically connected to the respective contact zones (for example by the so-called flip-chip method). Additionally, in most cases, an insulative layer is formed / placed between the substrate on which the antenna is printed and the chip, with means or openings foreseen to allow the contact between the chip/module and the contact zones of the antenna. Such processes are complicated and time and cost intensive. In addition, they also have quality problems in that the contact between chip/modules and antenna is not always the same which induces impedance differences in a production run.

Methods for the manufacture of contactless smart cards with an antenna made of wire are disclosed in documents DE 196 34 473 and DE 199 04 928. In both case, the chip/module is placed on the a substrate before the antenna wire. A RFID-module is first placed face down in a recess in the substrate, the module having two rear contact surfaces slightly protruding out of the substrate surface.

Then, the wire forming the antenna is placed on (embedded in) the surface of the substrate, and both ends of the wire are directly connected on both rear contact surfaces of the RFID module. Wire embedding techniques are slow and complicated. For high frequencies (13,56 MHz or higher), printed antennas are a much cheaper alternative.

The printed conductive structures disclosed in document FR 2 629 666 are at the end totally embedded in the IC card structure. These are in fact connections between the different electronic elements of the IC card. The electronic elements are first mounted and fixed in recesses of a card main substrates. An insulative layer is then printed over the whole substrate, having openings at those positions corresponding to the connection terminals (electrodes) of the electronic elements (IC chips for ex.).

Metal is fitted in the openings to provide through holes. Then, the printing process is carried out to form wiring lines 46 on the insulative layer. No antenna structure achieved by this process is disclosed in this prior art. The multi-layer structure (with the printed insulative layer) needs additional process steps to be achieved.

### Summary of the invention

It is therefore an aim of the present invention to improve the known technique to manufacture a contactless transponder unit and also to improve such units.

It is another aim of the present invention to provide a simple and effective manufacturing process.

A further aim of the present invention is to provide a RFID transponder unit in the shape of a card produced according to the manufacturing process.

An idea of the invention is to print the antenna structure after having placed a chip module in a recess of the basic substrate of the unit, said module being a packaging protecting the chip, useful for example if the final product (i.e. a card) is laminated. Hence, the module comprises contact surfaces connected to the chip which are also to be connected to the antenna. Since the electrical connection of the antenna to the module contact surfaces is achieved in the same process step during which the antenna is formed, the whole manufacturing process is very fast, easy to achieve, efficient and cost saving. Also, transponder units being produced by this process are more reliable.

The invention will be better understood in the following description together with the accompanying drawings.

### Brief description of the drawings

Figure 1 shows a basic substrate for a transponder unit, with a side view following the cut line A - A.
Figure 2 shows a basic substrate for a transponder unit having a chip module placed in the recess, with a side view following the cut line B - B.
Figure 3 shows a basic substrate of transponder unit, with a mounted chip module and printed antenna structure, with a side view following the cut line C - C.
Figure 4 shows the result of a serial application of the method of the invention on a sheet of basic substrate.
Figure 5 shows a a view similar to the cut B - B of figure 2 according to a variant.
Figure 6 shows a schematic representation of a chip module used in the method of the invention to produce a transponder unit.

### Detailed description of the invention

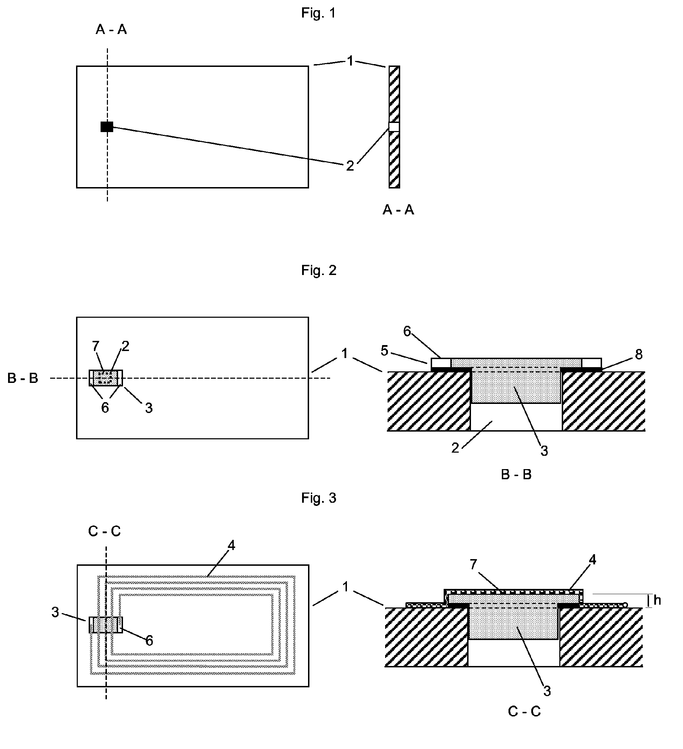

As represented in figure 1, a basic substrate 1 for a card is provided, said substrate being for example made of plastic, or other material known in the art.

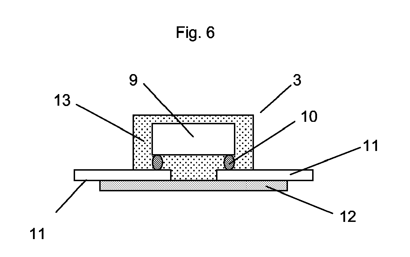

In this basic substrate 1, a recess 2 is formed. Preferably, the recess goes through the entire thickness of the substrate as can be seen in cut view A - A of figure 1. Once this recess 2 has been made, a chip module 3 is placed in said recess 2, as shown in figure 2 and in the cut view B - B of this figure. The module 3 for example is T-shaped with lateral parts 5 as represented in cut view B - B. An example of such module is represented in figure 6 with the general reference 3.

Further shown in cut view B - B of figure 2 is a layer of adhesive 8 for holding the module 3 on the substrate 1. In an ideal case, the adhesive 8 can be used to fill all the void spaces between the surface of the basic substrate and the chip module previous to the antenna printing step, in order to avoid that the conductive ink flows in/through these spaces.

As shown in figure 3 with cut view C - C, the substrate 2 with the module 3 has received an antenna structure 4 made by printing. To this effect, known specific conductive inks are used, as disclosed in document FR 2 753 305. As an example, a screen printing technique, well known in the art and not needing to be explained further here, can be used to form the antenna structure. Usually, the inks used for making such antennas have to be heated to be conductive, as explained in the prior art (for example FR 2 753 305). Many other printing methods can also be used to form the antenna structure, as for example ink-jet printing.

The two ends of the antenna are placed on the rear electrical contact surfaces 6. Typically, the height difference h between the front surface of the basic substrate 1 and the rear surface of the module 3 is about 100 micrometers.

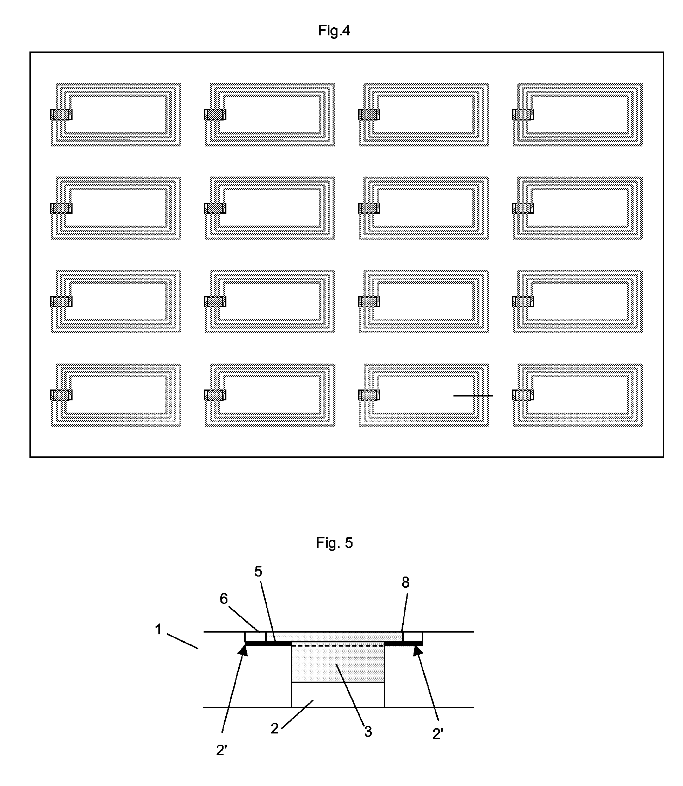

In figure 4, one has represented an array of antennas with modules (corresponding to the structure shown in figure 3) on a large substrate sheet: this represents a typical production situation in which such an array of antenna is produced by printing in one pass in a printing machine, rather than printing one antenna after the other, over the modules which have been previously positioned on the substrate sheet. The sheet is then cut into individual transponder units. Typically, when producing transponder cards, the basic elements (comprising a basic substrate on which are mounted the connected chip and antenna) produced according to the invention are called inlays. Additional sheets are placed on both sides of the inlays, this whole sandwich structure is then laminated and finally cut in cards format.

The adhesive layer 8 of Figure 2 is optional. It could be replaced by a single glue point under each of the lateral parts of the module 3, it being understood that an adhesive can be placed either on the substrate 1 or on the module 3.

In a variant which is represented schematically in figure 5 (with corresponding elements referenced in the same manner than in figures 1-4), it is possible to form a first step 2' in the recess 2 in order for the module 3 to be level with the surface of the substrate 1. The module 3 further comprises rear electrical contact surfaces 6 and central insulative rear surface 7 and the configuration of cut C - C of figure 3 applies correspondingly to this variant once the antenna 4 has been printed.

In figure 6, a non-limiting example of a chip module 3 that can be used in the present invention is shown. This chip module 3 comprises an insulation central part 12 (corresponding to the central insulative rear surface 7 of the preceding figures), two contacts 11 (corresponding to the rear electrical contact surfaces 6 of the preceding figures) which are to be connected to two ends of the antenna (not shown in this figure). The IC transponder chip 9 is connected to contacts 11 through ball connections 10 and is insulated by a global protection 13. As can be readily understood from the above description, this module 3 can be turned around and positioned in a substrate as represented in figure 2 (see cut B - B) and then connected to a printed antenna 4 using the methods described above.

As shown on figure 5, the heights of the insulative rear surface 12 and of both conductive rear surfaces 11 are not necessary the same.

In an other variant where (a part of) the rear surface of the module between the two rear electrical contact surface (7) is not printable, or for example conductive, an additional thin insulative sheet can be added over the rear face of the module (without covering the two electrical contact surface). This insulative sheet can be added after placement of the module in the recess and even help to fix the module. In this case, the partial printing of the antenna over the central part of the module is effectively made on the surface of this additional insulative sheet, and not directly on the rear surface of the module between the two rear electrical contact surface (7)

### List of numerical references :

1 card basic substrate
2 recess
2' first step in recess 2
3 chip module
4 printed antenna structure
5 lateral parts of the module
6 rear electrical contact surfaces
7 central insulative rear surface
8 adhesive layer
9 IC transponder chip
10 ball connection chip-module
11 conductive part of the module
12 insulative support part of the module
13 global protection

## Claims

1. Method of manufacturing a contactless transponder unit, having a chip module connected to a printed antenna structure, both destinated to be fully embedded in a structure, the method of manufacturing comprising the successive following steps:
• creating a recess at least in a surface of a basic substrate of the unit
• placing the chip module face down in the recess, the transponder module having two lateral parts comprising each on their rear face an electrical contact surface, such that the two lateral parts are supported by the surface of the basic substrate
• printing a conductive antenna structure over the surface of the basic substrate, whereby two extremities of the antenna structure are printed each directly on one of said electrical contact surfaces in order to achieve the electrical connection between the antenna and the chip module.

2. Method according to claim 1, wherein the recess is formed by a hole through the whole thickness of the basic substrate.

3. Method according to any one of the previous claims, wherein a first step of the recess is formed in such way to allow the chip module to be substantially even with the surface of the basic substrate.

4. Method according to any one of the previous claims, wherein adhesive means are placed between the two lateral parts of the chip module and the surface of the basic substrate.

5. Method according to any one of the previous claims, resulting in that there is no void space between surface of the basic substrate and the chip module.

6. Method according to any one of the previous claims, where a part of the conductive antenna structure is printed over a central insulative rear surface of the chip module.

7. A contactless transponder unit comprising a basic substrate part (1) with a recess (2), a chip module (3) placed face down in said recess (2) with electrical contacts (6) and a printed antenna (4) on said basic substrate (1), said antenna having two electrical contacts being printed over said contacts (6) of said module (3).

8. A unit as defined in claim 7, wherein the recess goes through the whole thickness of the basic substrate part (1).

9. A unit as defined in one of claims 7 to 8, wherein the recess (2) comprises a first step (2') allowing the chip module (3) to be substantially even with the surface of the basic substrate (1).

10. A unit as defined in one of claim 7 to 9, wherein adhesive means (8) are provided between the module (3) and the basic substrate.

11. A unit as defined in one of claims 7 to 10, wherein there is no void space between surface of the basic substrate and the chip module.

12. A unit as defined in one of claims 7 to 11, wherein a part of the antenna (4) is printed over a central insulative rear surface (7) of the chip module (3).

13. A card comprising a unit as defined in one of claims 6 to 12.
